# EUROPEAN PATENT APPLICATION

(11) **EP 1 467 403 A1**
(43) Date of publication of application: **13.10.2004**
(21) Application number: 02792026.3
(22) Date of filing: 26.12.2002
(51) Int. Cl.: H01L 21/304

(54) **POLISHING PAD, PROCESS FOR PRODUCING THE SAME, AND METHOD OF POLISHING**

(30) Priority: 28.12.2001 JP 2001400250
(71) Applicant: Asahi Kasei EMD Corporation, Tokyo 160-0023 (JP)
(72) Inventor: FURUKAWA, Shoichi, Fuji-shi, Shizuoka 417-0851 (JP); NAKAMURA, Atsushi, Fuji-shi, Shizuoka 417-0855 (JP)
(74) Representative: Weber, Thomas Dr.
(86) International application number: PCT/JP2002/013709
(87) International publication number: WO 2003/058698

(57) **Abstract**

According to the present invention, there is provided a polishing pad for polishing the surface of wafers for creating semiconductor integrated circuits, wherein said pad has a high polishing speed, said polishing is uniform, and said pad has a long life. Preferably, the polishing pad of the present invention comprises nonwoven fabric (base matrix) and a nonporous photo-setting resin that fills the space between the nonwoven fabric, and can be produced by impregnating the base matrix with a photo-sensitive resin composition containing at least one selected from the group consisting of a hydrophilic photopolymeric polymer or oligomer, and/or a hydrophilic photopolymeric monomer, and then photo-setting the same.

## Description

### Technical Field

The present invention relates to a polishing pad for use in the step of planarizing non planar steps on the surface of wafers for creating semiconductor integrated circuits by the chemical mechanical polishing process, a method of producing the pad, and method of polishing using the pad.

### Background Art

Processes for manufacturing semiconductor integrated circuits include the process of creating a conductive film on the surface of wafers and then forming a wiring pattern by photolithography and etching, and the process of forming an interlevel dielectric film on said wiring pattern. Through these processes, there is formed non planar steps consisting of conducting materials and insulating materials on the surface of wafers. In recent years, as miniturization and multi-layering of wiring pattern are in progress for the purpose of attaining higher density of semiconductor integrated circuits, techniques for planarizing non planar steps on the surface of wafers have become important in order to secure the depth of focus during the photolithograpy step.

As a method for planarizing non planar steps on the surface of wafers for creating semiconductor integrated circuits, currently the chemical mechanical polishing (hereinafter referred to as "CMP") is mainly used. The CMP method involves the use of a processing liquid (hereinafter referred to as "slurry") in which abrasive grains are dispersed in the form of slurry in a method of polishing by the combination of a chemical action by the processing liquid and a mechanical action by abrasive grains.

The polishing device for use in the CMP method is mainly composed of a platen, a wafer carrier head, a slurry supply nozzle, and a dresser. The polishing pad is stuck on said platen, and the wafer for creating semiconductor integrated circuits is attached to the wafer carrier head. Polishing by the CMP method is performed by pressing the surface to be polished of the wafer attached to the wafer carrier head against the polishing surface of the polishing pad, rotating the platen and said wafer carrier head and, at the same time, sandwiching the slurry supplied on the polishing surface in between the surface to be polished and the polishing surface.

During or prior to the polishing step, conditioning of the polishing pad usually is performed with a dresser onto which a diamond has been affixed. When it is performed during the polishing step, the conditioning treatment removes the surface layer of the polishing surface of the polishing pad thereby removing polishing crumbles, and thus plays a role of reviving the clean surface of the polishing pad. Also when it is performed prior to the polishing step, the conditioning treatment also plays a role of forming fine texture (in an order of a few µm) useful in transporting the slurry on the surface layer of the polishing side.

Though the slurry may vary depending on the material to be polished and the process, it generally comprises 100-80% by weight of a processing liquid which is a solution of an oxidizing agent and a solubilizing agent such as hydrogen peroxide (H₂O₂) and ferric nitrate (Fe(NO₃)₃), and 0-20% by weight of abrasive grains such as silica (SiO₂), ceria (CeO₂) and alumina (Al₂O₃). In the polishing step using a slurry, a chemical polishing action by dissolution, embrittlement etc. with the oxidizing agent, the solubilizing agent etc. in the processing liquid and a physical polishing action by abrasive grains take place at the same time.

In the polishing step by the CMP method, the first requirement for the polishing pad is a high polishing speed. In order to obtain a high polishing speed, the polishing surface of the polishing pad must have a structure that permits the efficient transport and retention of the slurry supplied from the slurry supply nozzle to the polishing surface along the entire surface of the contact interface between the polishing surface of the polishing pad and the surface to be polished of the wafer, and permits the extrusion of polished products or pad crumbles generated at the polishing area. For this purpose, polishing pads used in the conventional methods have a concave-convex structure (in an order of a few hundred µm) such as concentric or spiral grooves on the entire pad surface as well as a local concave-convex structure (in an order of a few dozen µm) such as air bubbles resulting from the manufacturing process.

The second requirement is the long life of the polishing pad, i.e. a large number of wafers can be polished without replacing the polishing pad. For this to be achieved, materials that constitute the polishing pad must have high abrasion resistance.

The third requirement is a high planarizing ability. Specifically, since copper wiring having a thickness of 1000 nm or greater must be polished in the polishing process of copper-plated wiring in the damascene wiring, a high planarizing ability is required in order to offset non planar steps copied onto the plating surface from trenches in the plating process. In the polishing of surfaces to be polished comprising different materials such as copper, an interlevel dielectric film and a barrier metal, non planarizing such as dishing and erosion tends to occur, and thus it is necessary to minimize non planarizing by using a polishing pad that is highly uniform itself and whose polishing surface has anti-deformation properties.

The conventionally known polishing pads for CMP may be divided into the polishing pads that utilize resins having a closed cell structure, the polishing pads that utilize resins having an open cell structure, the polishing pads that utilize resins having a nonporous structure or the two-layered polishing pads comprising two of them that are stuck to each other.

As the polishing pads that utilize resins having a closed cell structure, polishing pads comprising foaming polyurethane are known. Said polishing pads are manufactured in a process in which block-like urethane foams are produced in a batch type reaction and then said block-like foams are sliced into a sheet form. Since said polishing pads have hemispheric recesses (in an order of few dozen µm) derived from sliced air bubbles as local concave-convex structures, they are usually used with concave-convex structures covering the entire surface of the pad such as grooves formed by cutting operations.

However, since it is difficult to secure uniformity in reaction temperature and uniformity in foaming factor throughout the entire reaction vessel in the production of said polishing pads, it is difficult to produce products that are uniform throughout the polishing pads. Also since slurry components or products generated during polishing tend to precipitate in the above hemispheric recesses in said pads, they have a drawback of clogging by precipitates in a relatively short period of time. Thus, in order to maintain a high polishing speed, it is necessary to remove the clogged region on the surface of the polishing pad with the dresser frequently. Thus, they have problems that long dressing time in a total during polishing is required and that the polishing pad has a short life. Thus, the polishing pads comprising such polyurethane foams have not always satisfied the above three requirements for the polishing pad (thus, a high polishing speed, abrasion resistance, planarizing ability).

Representative polishing pads that use a resin having an open cell structure are polishing pads in which polyurethane has been impregnated into a polyester felt fiber sheet (see for example U.S. Pat. No. 4,927,432). Said polishing pad has been produced in a process in which a thermo-setting polyurethane dissolved in a solvent such as dimethylformamide, methylethyl ketone and tetrahydrofuran is impregnated into a felt fiber sheet, and after evaporating the solvent, the polyurethane is cured by heat. Said polishing pad has continuous air bubbles (in an order of few dozen to 200 µm) derived from felt as a local concave-convex structure. It can also be used without forming grooves etc. on the entire surface of the pad, since the slurry is transported via a mechanism in which it soaks into the entire polishing pad through said continuous air bubbles and soaks out by the pressure on the polished surface.

However, the process of producing said polishing pad mainly comprises a drying step and a heat reaction step, and the reaction mixture is at a state in which it tends to aggregate, and thus it is difficult to maintain the composition and physical properties of the polishing pad materials uniformly on microscopic levels. Furthermore, since it has compressibility derived from the open cell structure, it has a problem of poor planarizing ability. Furthermore, due to the presence of space between single fibers in felt sheet as continuous air bubbles, polishing crumbles generated in wafer polishing become tangled with said fiber and thus scratches may often appear in the polished product. Therefore, in the polishing pads in which polyurethane has been impregnated into a polyester felt fiber sheet, satisfactory results have not been obtained in terms of the polishing speed and the planarizing ability.

As a polishing pad using a resin having a nonporous structure, a solid homogeneous polymer such as polyurethane has been proposed (see U.S. Pat. No. 5,489,233). Also, there has been proposed a polishing pad using a resin having a nonporous structure created with a photo-setting resin using a polyurethane polymer (see U.S. Pat. No. 5,965,460). Unlike the above two polishing pads, said polishing pad has no essential concave-convex structure, and thus it is necessary to create local concave-convex structures (texture: in an order of a few µm) by conditioning treatment etc. Also, when the polishing pad is used, concave-convex structures (in an order of a few hundred µm) covering the entire pad such as grooves may be formed by cutting operation. In the case of the aforementioned polishing pads using a resin having a nonporous structure created with a photo-setting resin, concave-convex structures such as grooves can also be created by the photolithography method.

However, the above polishing pads using a resin having a nonporous structure only have concave-convex on the surface thereof by conditioning treatment etc., and thus they have a problem that they do not have sufficient ability to retain the slurry and have low polishing speeds. Besides, they have a problem that the life of the polishing pads is short.

It has also been proposed that in order to form concave-convex on the surface of the above polishing pad using a resin having a nonporous structure thereby to enhance the ability of retaining the slurry, a polymer filler, alumina, silica, a hollow ceramic balloon, hollow glass beads etc. can be added to the photo-setting resin which the polishing pad is comprised of (see U.S. Pat. No. 6,036,579). However, even if a filler is added to the resin, each filler is independently dispersed in the polishing pad and removed from the polishing surface by polishing, and thus it has little effect of enhancing abrasion resistance of the polishing surface and the extended life of the polishing pad cannot be expected. Thus, although drawbacks resulting from the production process of a polishing pad using a resin having a closed or open cell structure can be eliminated by the polishing pad using a resin having a nonporous structure, the above three requirements for the polishing pads could not be satisfied at the same time. Thus, with the polishing pad using a resin having a nonporous structure, uniformity as a whole can be obtained which contributes to the planarizing ability, it was not satisfactory in terms of high polishing speed (ability of transporting and retaining the slurry) or abrasion resistance.

### Disclosure of the Invention

According to the present invention, there is provided a polishing pad having a higher polishing speed than the conventional polishing pads, higher uniformity in polishing, and that has an extended life (i.e., a polishing pad is provided that simultaneously satisfies the above three requirements). Specifically, there is provided a polishing pad having a high planarizing ability that is suitable for polishing of thick conductor patterns such as the copper wiring pattern or the aluminum wiring pattern of the above-mentioned damascene wiring. According to the present invention, there is provided a method of polishing a wiring pattern comprising copper or aluminum formed on the surface of wafers for creating semiconductor integrated circuits using the above polishing pad. According to the present invention, furthermore, there is provided a method of manufacturing the above polishing pad for use in polishing the surface of wafers for creating semiconductor integrated circuits.

Thus, the first aspect of the present invention provides a polishing pad comprising fabric and a nonporous resin that fills the space between component fibers of the fabric.

In the polishing pad of the present invention, as the above fabric, nonwoven fabric comprising as a component fiber at least one selected from the group consisting of a polyester fiber, an acrylic fiber, a polyamide fiber, silk, wool and cellulose is preferably used. Furthermore, fabric comprising a fiber that has a moisture content of 10% or greater at 21°C and 80% RH is preferably used. Furthermore, fabric comprising a fiber having a tensile strength at dry of 3 g/D or greater is preferably used.

The above resin is preferably a photo-setting resin that was produced by photo-setting a photo-sensitive resin composition containing at least one selected from the group consisting of a hydrophilic photopolymeric monomer, a hydrophilic photopolymeric polymer and oligomer.

The second aspect of the present invention provides a method of polishing using a polishing pad comprising a nonporous photo-setting resin reinforced with fabric and the slurry.

In accordance with the method of the present invention, as the above fabric, there can be preferably used fabric comprising a fiber that has a moisture content of 10% or greater at 21°C and 80% RH, or fabric comprising a fiber that has a tensile strength at dry of 3 g/D or greater. Also, fabric comprising a fiber with a sectional form having a shape irregularity ratio of 1.2 or greater is preferably used.

The third aspect of the present invention provides a method of producing a polishing pad, which is characterized in impregnating a base matrix comprising fabric with a photo-sensitive resin composition and then irradiating said resin composition with an ultraviolet ray or a visible light thereby to cure the composition.

In order to offset heterogeneity in the size and density of air bubbles in the polishing pad that uses a resin having a foam structure of prior art and heterogeneity in polishing resulting from heterogeneity in compressibility associated thereby, a polishing pad using a resin having a nonporous structure is preferred. Even if a filler is put into the polishing pad that uses a resin having a nonporous structure of prior art, the polishing speed was low and abrasion resistance was poor.

Thus in order to resolve the above problems, the present inventors have come up with an idea of combining a base matrix comprising a fabric with a resin having a nonporous structure. U.S. Pat. No. 5,489,233 that discloses the above polishing pad comprising a solid homogeneous polymer (a nonporous structure) describes that heterogeneity originally present in the bulk substance is not preferred in order to suppress variation in polishing. Furthermore, U.S. Pat. No. 6,036,579 that discloses the polishing pad comprising a photo-setting resin (a nonporous structure) describes that preferably a filler is not added, and if added, a polymer filler or a particulate filler with a mean size of 1-1000 nm can be added. Thus, although the addition of fabric was totally unexpected in terms of securing transparency for "photosensitization" of photo-sensitive resin compositions according to these disclosures, the present inventors have thought that the problems could be resolved by optimizing the reaction condition and the composition of the photo-sensitive resin used, and thereby completed the present invention.

### Best Mode for Carrying Out the Invention

In the following, the present invention is described in detail.

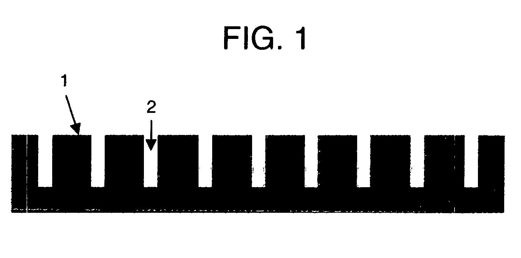

Fig. 1 shows a cross sectional diagram of an embodiment of the polishing pad according to the present invention. Said diagram shows a cross section along the direction of thickness of the polishing pad, in which 1 denotes the polishing surface and 2 denotes grooves (in an order of a few hundred µm) formed throughout the polishing pad. In the polishing step, the polishing surface 1 is pressed against the surface to be polished of the wafer. Grooves 2 are regions for transporting the slurry to the entire area of the polishing surface. The polishing pad itself becomes abraded by wafer polishing, and when it is abraded until there are no grooves 2 left, the transportation efficiency of the slurry decreases, and thus normally it is replaced with a new polishing pad before there are no grooves 2 left.

The polishing pad of the present invention comprises a base matrix comprising a fabric and a nonporous resin that fills the space between component fibers of the base matrix.

Unlike polishing pads that use a resin having a closed cell structure or polishing pads that use a resin having an open cell structure, the polishing pad of the present invention is not porous and thus it develops no heterogeneity in polishing resulting from distribution of air bubbles and compressibility. Also, unlike the conventional polishing pads that use a resin having a nonporous structure, the polishing pad of the present invention uses a base matrix comprising a fabric that is continuous throughout the polishing pad, thereby making the entire polishing pad a tenacious structure, which suppresses abrasion and which can increase the number of wafers to be polished with one pad.

Furthermore, by using said base matrix with a higher water absorption and/or combining the base matrix with a photo-setting resin having a high water absorption, the ability of retaining the slurry used in the polishing step and the polishing speed can be increased. Specifically, when a slurry that performs polishing mainly by a chemical action as described below is used, such enhanced water absorption exhibits an effect in retaining the slurry.

Also, the concave-convex structure (this concave-convex structure is derived from the structure of the fabric itself) in an order of few dozen µm on the surface of the fabric exposed on part of the polishing surface of the polishing pad contributes to the efficient transport and retention of the slurry, and thus enables to attain a high polishing speed. Specifically, when a slurry that performs polishing mainly by a mechanical effect is used as described below, such a concave-convex structure exhibits an effect in transporting and retaining the slurry. Also by using a concave-convex structure resulting from the structure of the fabric itself, it is possible to circumvent the problems such as the above-mentioned clogging of air bubbles or scratches due to tangling of polished crumbles into continuous air bubbles.

The fabric for use as the base matrix in the polishing pad of the present invention may be woven or nonwoven fabric, and preferably nonwoven fabric is used. As methods of making nonwoven fabric, the immersion adhesion method, the needle punch method, the spun bond method, the stitch bond method, or a wet type water jet method etc. are known. The fabric for use in the present invention is preferably those that are highly dense and homogeneous in order to maintain high and uniform polishing speeds. An example of preferred fabric is nonwoven fabric produced by the water jet method. Also preferred are those nonwoven fabric that was created by another method and compressed by the press etc. to a high density.

As a component fiber of said base matrix, chemical synthetic fibers such as a polyester fiber, an acrylic fiber and a polyamide fiber, and natural fibers such as cellulose, wool and silk can be used. Among them, fabric comprising a fiber having a high tensile strength, fabric comprising a fiber having a high hydrophilicity, or nonwoven fabric comprising porous, irregular shaped cross sectional or ultrathin fibers are preferably used. Specifically, among these base matrixes, nylon nonwoven fabric, rayon nonwoven fabric and nonwoven fabric comprising porous fibers are used more preferably in terms of the polishing speed.

As the slurry for polishing copper for use in the damascene wiring described above in the polishing method of the present invention, two types of slurries are preferably used: slurries that use aluminum oxide as abrasive grains and polish mainly by a mechanical action, and slurries that use colloidal silica as abrasive grains and polish mainly by a chemical action such as oxidation and complex formation. When a slurry that polishes mainly by a chemical action is used, it is also possible to obtain the planarization of polishing, i.e. to minimize dents, called dishing, in copper wirings at the edge of the polished surface, or dents, called erosion, at regions of high copper wiring density.

Specifically, among the base matrixes in the present invention, fabric comprising a fiber having an excellent tensile strength exhibits an excellent polishing performance with a slurry that polishes mainly by a mechanical action. This is because, it is believed, the fiber itself partly protruding from the polishing surface (concave-convex in an order of few dozen µm of the polishing surface as mentioned above) functions as the polishing material and, since it hardly warps by load, can effectively press the abrasive grains against the polished surface. Specifically, fibers having a tensile strength at dry of 3 g/D or greater are preferred, and fibers having a tensile strength of 4.5 g/D or greater are more preferred. Examples of such fibers include an acrylic fiber, a nylon fiber, or some of a polyester fiber. The tensile strength of fibers can be determined based on the method of determination provided in JIS L1013 (Test method of chemical fiber filaments).

Also, fabric comprising a fiber having a high water absorption exhibits an excellent polishing performance with a slurry that mainly polishes by a chemical action. This is because, it is believed, the fiber exposed on part of the polishing surface sucks up the processing liquid of the slurry and supplies it to the surface to be polished. Specifically, fibers having a moisture content of 10% or greater at a condition of 21°C and 80% RH are preferred, and fibers having a moisture content of 15% or greater are more preferred. Examples of such fibers include a cellulose fiber such as rayon. The moisture content of fibers can be determined based on the method of determination provided in JIS L1013 (Test method of chemical fiber filaments).

Even if a fiber having a moisture content of 10% or less at a condition of 21°C and 80% RH is used, a polishing pad that uses fabric comprising a porous fiber having holes in the cross section or a fiber having notches or gaps on the surface exhibits an excellent polishing ability with a slurry that mainly polishes by a chemical action. This is because, it is believed, fibers exposed on the polishing surface are crushed into small pieces due to the conditioning treatment or load by the wafer, suck up the processing liquid of slurry, or serve as a place to capture abrasive grains. A similar effect can be expected when fabric comprising a fiber with an irregular shaped cross section having a large surface area in stead of a circular cross section is used.

A degree of shape irregularity is defined by the shape irregularity ratio determined by the following method. First, a fabric is cut with a cutter so as to expose the cross section of the fiber. Then, a photograph of the cross section is taken using an optical microscope or an electron microscope. From the photograph of the cross section, the length S of the periphery of the cross section of one fiber constituting the fabric is determined (when the cross section of the fiber has one or more holes, the sum of periphery length of each hole is added to S). One half of the mean of the maximum and the minimum of a line segment cut out by the periphery of said cross section when a plurality of straight lines that cross the center of gravity of the fiber's cross section are drawn is set as a virtual radius a. The radius of a circle whose length of outer periphery is S is set as b (b can be determined by b=S/2π). Though the shape of each fiber constituting the fabric has a similar tendency, they are slightly different from each other, and thus, after selecting five arbitrary fibers from the photograph of the above cross section, b/a is calculated for each fiber and the mean thereof is determined. This value is defined as the shape irregularity ratio. When the shape irregularity ratio is greater than 1, the fiber has an irregular shape, and according to the present invention, fabric comprised of fibers having a shape irregularity ratio of 1.2 or greater is preferred, and that having a shape irregularity ratio of 1.4 or greater is more preferred.

Since the above base matrix (fabric) is impregnated with a photo-sensitive resin composition and then irradiated with an ultraviolet ray or a visible light to cure said resin composition, a base matrix, even if it is opaque per se, can be used in the present invention if transparency of an extent that can sufficiently trigger a photo-setting reaction is obtained at a state in which a photo-sensitive resin composition is impregnated thereinto.

The resins for use in the present invention are required to be nonporous resins, and preferably nonporous photo-setting resins (obtained by photo-setting photo-sensitive resin compositions). When thermosetting resins are used to produce the nonporous polishing pads of the present invention, polishing pads may sometimes warp due to post-setting residual stress derived from heat distribution etc. In contrast, when photo-setting resins are used, the problem of warping seldom develops because the photo-setting reaction of photo-sensitive resin compositions proceed in a short period of time as compared to thermosetting. Furthermore, the reaction proceeds more uniformly as compared to thermosetting, with a result that the photo-setting resins, reaction products, have a more homogeneous composition than the thermosetting resins.

In the CMP process, the amount of polishing is monitored by an optical method, and thus an opening is sometimes made at part of the polishing surface of the polishing pad to mount a transparent member (hereinafter referred to as window) (see for example U.S. Pat. No. 5,893,796). When fabric and a photo-setting resin which are preferred embodiments of the present invention are used, the process of manufacturing a polishing pad having the above window can be simplified. Thus, a photo-sensitive resin composition is impregnated into fabric in which the part corresponding to the opening has been cut, and cured by light irradiation, so that said window can be formed within the polishing pad.

Said photo-setting resin has been cured by irradiating a photo-sensitive resin composition with an ultraviolet ray or a visible light, and said photo-sensitive resin composition contains at least one of a photopolymerizing polymer or oligomer and a photopolymerizing monomer. According to the present invention, it is preferred to use a photo-sensitive resin composition containing at least one of a hydrophilic photopolymerizing polymer or oligomer, a hydrophilic photopolymerizing monomer in order to enhance water absorption of the pad.

As said photopolymerizing polymer or oligomer, there can be mentioned unsaturated polyester, polyether(meth)acrylate, polyester(meth)acrylate, polybutadiene(meth)acrylate, polyepoxy(meth)acrylate and the like.

Specifically, as a constituent component of the photo-sensitive resin composition, in order to obtain a photo-setting resin having a high water absorption, those having a hydroxyl group, a carboxyl group or a phosphate group at the end or at the side chain are preferred. For example, there can be mentioned those having a hydroxyl group or a carboxyl group at the end or at the side chain of the polymer chain as unsaturated polyesters, or a polymer or an oligomer in which a monoisocyanate having an ethylenic unsaturated group was bound to a hydroxyl group of an unsaturated polyester polymer leaving only the carboxyl group.

As the above photopolymerizing monomers, compounds having at least one ethylenic unsaturated groups at the end or at the side chain are preferred. Ethylenic unsaturated groups refer to those included in acrylate, methacrylate, vinyl, allyl and the like. Specifically, there can be compounds having one of various ethylenic unsaturated groups such as lauryl methacrylate, N-(3-dimetylaminopropyl) (meth)acrylamide, hydroxyethyl(meth)acrylate, hydroxypropyl(meth)acrylate, ethyl (meth) acrylate, propyl(meth)acrylate and the like, and multifunctional monomers such as ethyleneglycol di(meth)acrylate, diethyleneglycol di(meth)acrylate, 1,4-butandiol di(meth)acrylate, 1,6-hexanediol di(meth)acrylate, trimethylolpropane tri(meth)acrylate, glycerin di(meth)acrylate, triethyleneglycol di(meth)acrylate, polyethylene glycol #200 di(meth)acrylate, polyethylene glycol #400 di(meth)acrylate, 1,3-butanediol di(meth)acrylate, neopentylglycol di(meth)acrylate, 1,10-decanediol di(meth)acrylate, di(meth)acrylate of ethylene oxide adducts of bisphenol A, triallyl isocyanurate, isocyanuric acid ethylene oxide-modified di(meth)acrylate, isocyanuric acid ethylene oxide-modified tri(meth)acrylate, ethylene oxide-modified trimethylolpropane tri(meth)acrylate, pentaerythritol tri(meth)acrylate, pentaerythritol tetra(meth)acrylate, dipentaerythritol hexa(meth)acrylate, 1,9-nonanediol di(meth)acrylate, tri(meth)acrylate of three molar ethyleneoxide adducts of pentaerythritol, oligopropyleneglycol di(meth)acrylate, and polytetramethyleneglycol di(meth)acrylate.

In order to enhance the water absorption of photo-setting resins, alkyleneglycolic and alykyleneethereal monomers or photopolymerizing monomers containing hydroxyl groups in the molecule are particularly preferred among these photopolymerizing monomers.

Also preferred are photopolymerizing monomers containing an urethane group in the molecule that are obtained by reacting hydroxy(meth)acrylates such as pentaerythritol tri(meth)acrylate, 2-hydroxyethyl(meth)acrylate, 2-hydroxypropyl(meth)acrylate and 2-hydroxybutyl(meth)acrylate with monoisocyanate.

Photopolymerizing monomers containing urethane groups in the molecule obtained by reacting a hydroxyl group-containing compound with monoisocyanate having an ethylenic unsaturated group are also preferred.

As specific examples, there can be mentioned photopolymerizing monomers that are obtained by reacting a hydroxyl group-containing compound with monoisocyanate having an ethylenic unsaturated group, said hydroxyl group-containing compound including polyether polyols such as poly(oxypropylene)polyol, copoly(oxyethylene-oxypropylene)diol, and polytetramethyleneetherdiol, polyester polyols such as polyester polyol, polycaprolactone polyol and polycarbonate polyol, straight-chain polyols such as 1,4-butanediol, 1,5-pentanediol, 1,6-hexanediol and polybutadine polyol, trimethylol propane, neopentyl glycol, methylpentane diol, acryl polyol, phenol resin polyol, epoxypolyol, polyester-polyether polyol, acryl, styrene, vinyl added and/or dispersed polyether polyols, carbonate polyol, ethylene glycol, diethylene glycol, propylene glycol, dipropylene glycol, caprolactone diol, hydroxyethoxylated bisphenol A, hydroxyethoxylated bisphenol S, monofunctional alcohols, and saturated and unsaturated polyesters.

Also, any one or a combination of a plurality of these hydroxyl group-containing compounds may be used. Diamines such as 3,3-dichloro-4,4-diaminophenylmethane may also be used in combination with these hydroxyl group-containing compounds. As used herein, said hydroxyl group-containing compounds preferably have a plurality of hydroxyl groups in the molecule.

As the above monoisocyanate, 2-isocyanate ethylmethacrylate, phenyl isocyanate, 3-isocyanate propyl triethoxysilane etc. are preferred. Among them, 2-isocyanate ethylmethacrylate has an ethylenic unsatuated group that functions as a binding point for photo-setting or thermosetting, and by adjusting the ratio of mixing 2-isocyanate ethylmethacrylate with other monoisocyanates having no ethylenic unsatuated groups, the hardness of the polishing pad can be controlled.

In contrast, when a monoisocyanate obtained by reacting an isocyanate group at one end of diisocyanate with a hydroxyl group-containing compound is used, aggregation of resin after photo-setting becomes large and thus it is not preferred. This means a higher probability that, when used in polishing, polishing crumbles with large diameters tend to be formed and thus may cause scratches on the subject to be polished.

In a photo-sensitive resin composition for use in the present invention, preferably 80-5% by weight of a photopolymerizing monomer is blended with 20-95% by weight of a photopolymerizing polymer or oligomer. More preferably, 70-20% by weight of a photopolymerizing monomer is blended with 30-80% by weight of a photopolymerizing polymer or oligomer. Specifically, it is preferred that an alkyleneglycolic, an alkyleneethereal, or a hydrophilic photopolymerizing polymer or oligomer or a hydrophilic photopolymerizing monomer containing at least one of hydroxyl group, carboxyl group and phosphate group in the molecule is blended to 20% by weight or greater.

The photo-sensitive resin composition as claimed in the present invention usually uses with an addition of a photo polymerization initiator. Said photo polymerization initiators include benzophenones, acetophenones, α-diketones, acyloins, acyloinethers, benzylalkylketals, polynuclear quinones, thioxanthones, acylphosphines and the like. Specifically preferred are benzophenone, chlorobenzophenone, acetophenone, benzyl, diacetyl, benzoin, pivaloin, benzoinmethylether, benzoinethylether, benzyldiethylketal, benzyldiisopropylketal, anthraquinone, 1,4-naphthoquinone, 2-chloroanthraquinone, thioxanthone, 2-chlorothioxanthone, acylphosphineoxide and the like. They may be used alone or in combination.

The photo polymerization initiators may preferably be used at 1-20 parts by weight relative to 100 parts by weight of the sum of the above photopolymerizing polymer or oligomer and a photopolymerizing monomer. According to the present invention, the presence of fabric reduces light transmission and thus it is preferred to use a photoinitiator having a high photo-sensitivity.

Furthermore, to said photo-sensitive resin composition other additives may be added as appropriate as long as it does not damage the effect of the present invention.

The polishing pad of the present invention may be obtained by impregnating said fabric with the above photo-sensitive resin composition by coating or dipping, and then irradiating an ultraviolet ray or a visible light of a wavelength corresponding to the photo-sensitivity of said resin composition so as to cure said resin composition to form a photo-setting resin.

The nonporous resin in the polishing pad of the present invention means a resin having a porosity of 10% or less. The porosity may be defined as follows. From a subject for which the porosity is to be measured, ten samplings are performed, and the sample sections are sliced to expose a cross section, of which photographs are taken by an optical microscope or an electron microscope at a magnification of 60. The ratio of an area of holes relative to a cross sectional area of the sliced sample section of 1 mm long and 1 mm wide is determined by image processing etc., and the mean of ten determinations is defined as a porosity. As used herein, when the polishing pad is composed of a fabric portion and a resin portion as in the present invention, the porosity of the polishing pad means the porosity calculated based on the part excluding the fabric in the polishing pad (the area of holes/the area of the part excluding the fabric in the polishing pad (the area of the resin + the area of holes)). The resin for use in polishing pad of the present invention is nonporous, and even if air bubbles that entered during the impregnation process into fabric are present, the porosity of the polishing pad is 10% or less. In order to maintain uniformity in polishing speed and polishing, the porosity of the polishing pad is preferably 5% or less, and more preferably 2% or less.

Since the polishing pad of the present invention uses a nonporous resin as described above, the slurry cannot be retained and transported via continuous air bubbles unlike the polishing pad of prior art that uses a resin having an open cell structure. However, by using fabric as the substrate, it can have an ability of efficiently retaining and transporting the slurry on the surface of the wafer. Thus, as mentioned above, whether a slurry that polishes mainly by a chemical action is used, or a slurry that polishes mainly by a mechanical action is used, it is possible to efficiently retain and transport the slurry on the surface of the wafer depending on the characteristics or structure of fabric. Furthermore, fabric as the base matrix is subjected to polishing at a state in which most portions excluding the parts exposed on the polishing surface are embedded in the resin, raising on the polishing surface can be minimized. Thus, it is possible to accomplish the basic requirement of the CMP polishing pad of selectively polishing and planarizing the protruding portions on the surface of the wafer.

The ratio of the fabric and the resin in the polishing pad of the present invention is established so that the ratio of the area of the fabric as defined below comprises preferably 5-80%, and more preferably 10-60% depending on the type of the resin and the type and structure of the fabric. From the region to be used in the polishing of the polishing pad, ten samplings are performed, and the sample sections are sliced to expose a cross section, of which photographs are taken by an optical microscope or an electron microscope at a magnification of 60. The ratio (%) of an area of the fabric relative to a cross sectional area of the pad of 1 mm long and 1 mm wide is determined by image processing etc., and the mean of ten determinations is defined as an area ratio of fabric.

When fibers of the fabric used as the base matrix are thin, the fabric has a low density and the area ratio of fabric is 5% or less, a sufficient polishing speed cannot be obtained and it is not preferred. When the area ratio of fabric exceeds 80%, the impregnation of the resin becomes difficult and thus nonporous resins having a low porosity cannot be obtained, which is not preferred.

In a preferred embodiment of the polishing pad of the present invention, by using a photo-setting resin having a high water absorption and/or a fabric having a high water absorption (specifically it becomes necessary when a slurry that polishes mainly by a chemical action is used), as described above, the water absorption of the region used for polishing becomes high, hence resulting in an enhanced ability of retaining the slurry. The water absorption of the polishing pad in a preferred embodiment of the present invention is 1-15%, more preferably 2-10%, and even more preferably 4-10%. For the polishing pad having a water absorption of 1% or less, the ability of retaining the slurry becomes insufficient and thus a sufficient polishing performance cannot be obtained. At a water absorption of 15% or greater, the strength of the polishing pad decreases which may cause inconveniences such as the reduced ability of planarizing and the quickened abrasion of the polishing pad. As used herein the water absorption is determined as follows. Thus, (1) both sides of the pad are cut to expose the fabric on the surface to prepare a test sample. (2) The above sample is dried under vacuum at 50°C for 1 hour, and then the weight (A) is measured. (3) After soaking the sample in water at 23°C for 24 hours to impregnate the sample with water, the surface of said sample is wiped to remove water drops, and the weight (B) is measured. (4) The water absorption of the sample is determined based on the water absorption = {(B-A)/A}x100(%).

On the polishing pad thus obtained as described above, grooves 2 are formed on the polishing surface by cutting as shown in Fig. 1. The representative grooves are about 200-1000 µm deep and about 100-500 µm wide, and have a groove-to-groove pitch of about 1-5 mm.

In performing the polishing of the wafer using the polishing pad of the present invention, grooves are first formed on the polishing pad which is then stuck on the platen of the CMP polishing device. Then, the surface of the polishing surface is subjected to conditioning treatment (formation of fine texture) with a dresser, and fibers constituting the fabric are simultaneously exposed on the surface. On the other hand, the wafer is mounted to the wafer carrier head. Polishing is performed by supplying the slurry from the slurry supply nozzle to the polishing surface at a state in which the wafer is being pressed against the polishing pad while rotating the wafer carrier head and the platen.

When a slurry that polishes mainly by a chemical action is used at this time, fabric comprising a fiber having a high moisture content or fabric comprising a fiber having a high shape irregularity ratio is preferably used to obtain a high polishing speed. Furthermore, a slurry that polishes mainly by a mechanical action is used, fabric comprising a fiber having a high tensile strength at dry is preferably used to obtain a high polishing speed as described above.

When the polishing speed has become low, the polishing surface is subjected to conditioning treatment to expose a fresh polishing surface to be used. Since the polishing surface becomes abraded by the polishing process and the conditioning treatment, it should be replaced with a new one before the remaining portions of the above grooves disappear.

As used herein, another material can be stuck on one side of the polishing pad of the present invention as desired, and can be used as a double-layer polishing pad. At this time, the effect of the present invention can be obtained by using the side of the polishing pad of the present invention as the polishing surface.

### Brief Explanation of the Drawings

Fig. 1 is a cross sectional diagram of an embodiment of the polishing pad according to the present invention.

### Examples

The present invention will now be explained with reference to the following Examples. It should be noted, however, that the present invention is not limited to these Examples in any way.

### Example 1

A fabric comprising a nonwoven fabric ("Shaleria" manufactured by Asahikasei K.K.) with a thickness of 1 mm comprising a porous acrylic fiber having a tensile strength at dry of 3.1 g/D, a shape irregularity ratio of 1.5 and a moisture content of 1.2% was impregnated with a photo-sensitive resin composition comprising a unsaturated polyester oligomer 65% by weight, a hydroxyl group-containing monofunctional monomer 17% by weight, another monomer 16% by weight and a photo polymerization initiator 2% by weight, and then an ultraviolet ray was irradiated from both sides to prepare a polishing pad with a thickness of 1.5 mm and a diameter of 50 cm. The area ratio of fabric of 35%, a water absorption of 5.6% and a porosity (a value calculated for the region excluding the fabric in the polishing pad) of 2.0%.

After creating grooves for slurry transport by machining, the polishing pad was mounted to the CMP polisher, and the mean polishing speed of the copper film on the silicon wafer was determined using a slurry of alumina abrasive grains to obtain a polishing speed of 520 nm/min at the maximum. Also, the amount of abrasion of the pad was determined to be 0.5 µm/min under a dress condition of 100-grid diamond size.

### Example 2

A fabric comprising a nonwoven fabric ("ColdonR0260T" manufactured by Asahikasei K.K.) with a thickness of 1 mm comprising a rayon fiber having a tensile strength at dry of 2.1 g/D, a shape irregularity ratio of 1.2 and a moisture content of 21.3% was impregnated with a photo-sensitive resin composition as in Example 1, and then an ultraviolet ray was irradiated from both sides to prepare a polishing pad with a thickness of 1.5 mm and a diameter of 50 cm. The area ratio of fabric of 13%, a water absorption of 7.3% and a porosity (a value calculated for the region excluding the fabric in the polishing pad) of 0.1% or less.

After creating grooves for slurry transport by machining, the polishing pad was mounted to the CMP polisher, and the mean polishing speed of the copper film on the silicon wafer was determined using a slurry of silica abrasive grains to obtain a polishing speed of 660 nm/min at the maximum. Also, the amount of abrasion of the pad was determined to be 0.5 µm/min under a dress condition of 100-grid diamond size.

### Example 3

A photo-sensitive resin composition was prepared in the following procedure.
(A) To an unsaturated polyester with a molecular weight of 2400 that was synthesized by a usual polycondensation reaction at a ratio of one mole part of diethylene glycol, 0.5 mole part of adipic acid and 0.5 mole part of fumaric acid, di-N-butyltin laurate was added as an urethanation catalyst, and then 6.3% of 2-isocyanatoethyl methacrylate at a weight ratio to the above polyester was added dropwise under stirring to perform urethanation treatment. As used herein the above urethanation catalyst was added to 5% in a weight ratio to 2-isocyanatoethyl methacrylate.
(B) To 3-methyl-1,5-pentanediol, di-N-butyltin laurate was added as an urethanation catalyst, and then two mole part (2.6-fold amount on a weight ratio) of 2-isocyanatoethyl methacrylate to one mole part of the above diol was added dropwise under stirring to perform urethanation treatment. As used herein the above urethanation catalyst was added to 5% in a weight ratio to 2-isocyanatoethyl methacrylate.
(C) To caprolactone diol, di-N-butyltin laurate was added as an urethanation catalyst, and then two mole part (0.56-fold amount on a weight ratio) of 2-isocyanatoethyl methacrylate to one mole part of the above diol was added dropwise to perform urethanation treatment. As used herein the above urethanation catalyst was added to 5% in a weight ratio to 2-isocyanatoethyl methacrylate.

After the reactions, the urethanated products (A), (B) and (C), and (D) triallyl isocyanurate were mixed at a weight ratio of 1/1/1/0.2, to which were added 2,2-dimethoxy-2-phenylacetophenone as a photopolymerization initiator and 2,6-di-tert-butyl-4-methylphenol as a polymerization inhibitor at a weight ratio of 2% and 0.038%, respectively, relative to the total amount of (A), (B), (C) and (D) to prepare a sticky photo-sensitive resin composition.

A fabric comprising a nonwoven fabric ("ColdonL0170T" manufactured by Asahikasei K.K.) with a thickness of 0.6 mm comprising a nylon fiber having a tensile strength at dry of 4.9 g/D, a shape irregularity ratio of 1.0 and a moisture content of 5.2% and an acrylic fiber nonwoven fabric ("Shaleria" manufactured by Asahikasei K.K.) with a thickness of 0.6 mm that were overlaid and pressed was impregnated with a photo-sensitive resin composition prepared in the above-mentioned procedure, and then an ultraviolet ray was irradiated from both sides to prepare a polishing pad with a thickness of 1.5 mm and a diameter of 50 cm by the UV crosslinking method.

With the side of the nylon fiber nonwoven fabric as the polishing surface, the region used for polishing of the fabric had an area ratio of fabric of 42%, water absorption of 2.1% and a porosity (a value calculated for the region excluding the fabric in the polishing pad) of 1.3%. After creating grooves for slurry transport by machining, the polishing pad was mounted to the CMP polisher, and the mean polishing speed of the copper film on the silicon wafer was determined using a slurry of alumina abrasive grains as in Example 1 to obtain a polishing speed of 640 nm/min at the maximum. Also, the amount of abrasion of the pad was determined to be 0.1 µm/min under a dress condition of 100-grid diamond size.

### Comparative Example 1

Under the same condition as in Example 1, except that the photo-sensitive resin composition was used alone without fabric, a polishing pad having a thickness of 1.5 mm and a diameter of 50 cm was prepared in which grooves for slurry transport were created on the polishing surface. The water absorption of said photo-setting resin was 3.0%.

The mean polishing speed of the wafer which was determined under the same condition as in Example 1 was 250 nm/min. The amount of abrasion of the pad which was determined under the same dress condition as in Example 1 was 3 µm/min.

### Comparative Example 2

Under the same condition as in Example 1, except that a urea filler was mixed in stead of a base matrix comprising a fabric, a polishing pad having a thickness of 1.5 mm and a diameter of 50 cm was prepared in which grooves for slurry transport were created on the polishing surface.

The mean polishing speed of the copper film on the wafer which was determined under the same condition as in Example 1 was 210 nm/min. The amount of abrasion of the pad which was determined under the same dress condition as in Example 1 was 3 µm/min.

### Comparative Example 3

Using a polishing pad comprising a resin having a porosity (a value calculated for the region excluding the fabric in the polishing pad) of 75% having an open cell structure in which a felt comprising a polyester fiber has been impregnated with a urethane elastomer, the mean polishing speed of the wafer was measured under the same condition as in Example 1, and was found to be 240 nm/min.

### Comparative Example 4

Under the polishing condition using a silica slurry as in Example 2 except that a rayon fiber nonwoven fabric ("ColdonR0260T" manufactured by Asahikasei K.K.) was used alone as a polishing pad without being impregnated with a photo-sensitive resin composition and except that grooves for slurry transport were not created, the mean polishing speed of the copper film on the wafer which was determined was found to be 320 nm/min.

### Industrial Applicability

According to the present invention, there is provided a polishing pad having an excellent abrasion resistance, polishing speed and uniformity in polishing, and thus time required in the polishing step of wafers for creating semiconductor integrated circuits can be drastically curtailed. Also according to the present invention, even for wirings (for example, thick conductor patterns such as the copper wiring pattern and aluminum wiring pattern of damascene wiring) containing copper or aluminum formed on the surface of wafers for creating semiconductor integrated circuits or insulator patterns of silicon dioxide etc., there can be provided a polishing pad that can be preferably used when planarization properties such as STI (Shallow Trench Isolation) are required.

## Claims

1. A polishing pad for use in surface polishing of wafers for creating semiconductor integrated circuits, comprising fabric and a nonporous resin that fills the space between component fibers of the fabric.

2. The polishing pad according to claim 1, wherein said fabric is nonwoven fabric comprising, as a component fiber, at least one selected from the group consisting of a polyester fiber, an acrylic fiber, a polyamide fiber, silk, wool and cellulose.

3. The polishing pad according to claim 1 or 2, wherein said resin is a photo-setting resin that was produced by photo-setting a photo-sensitive resin composition containing at least one selected from the group consisting of a hydrophilic photopolymeric monomer, a hydrophilic photopolymeric polymer and oligomer.

4. The polishing pad according to claim 2 or 3, wherein a fabric comprising a fiber that has a moisture content of 10% or greater at 21°C and 80% RH is used.

5. The polishing pad according to claim 2 or 3, wherein a fabric comprising a fiber having a tensile strength at dry of 3 g/D or greater is used.

6. A method of polishing a wiring containing copper or aluminum formed on the surface of wafers for creating semiconductor integrated circuits, wherein said polishing is performed using a polishing pad comprising fabric and a nonporous photo-setting resin that fills the space between component fibers of the fabric and a slurry.

7. The method according to claim 6, wherein said fabric is a fabric comprising a fiber having a moisture content of 10% or greater at 21°C and 80% RH.

8. The method according to claim 6, wherein said fabric is a fabric comprising a fiber having a tensile strength at dry of 3 g/D or greater.

9. The method according to claim 6, wherein said fabric is a fabric comprising a fiber having a shape irregularity ratio of 1.2 or greater.

10. A method of producing polishing pad for use in surface polishing of wafers for creating semiconductor integrated circuits, wherein said method comprises impregnating a base matrix comprising fabric with a photo-sensitive resin composition and then irradiating said resin composition with an ultraviolet ray or a visible light thereby to cure the composition.
